**Europäisches Patentamt**

**European Patent Office**

**Office européen des brevets**

(11) Numéro de publication : **0 398 780 B1**

## (12) FASCICULE DE BREVET EUROPEEN

(45) Date de publication du fascicule du brevet :
26.01.94 Bulletin 94/04

(51) Int. Cl.⁵ : **G01R 29/26**

(21) Numéro de dépôt : **90401198.8**

(22) Date de dépôt : **04.05.90**

(54) **Chaîne de mesure de la caractéristique de bruit de phase additif d'un composant au voisinage d'une fréquence porteuse.**

(30) Priorité : **19.05.89 FR 8906586**

(43) Date de publication de la demande :
**22.11.90 Bulletin 90/47**

(45) Mention de la délivrance du brevet :
**26.01.94 Bulletin 94/04**

(84) Etats contractants désignés :
**DE GB IT NL**

(56) Documents cités :
**FR-A- 2 451 584**
**PROCEEDINGS OF THE 41st ANNUAL FRE-QUENCY SYMPOSIUM 1987, IEEE Catalog no. 87 CH 2427-3, Library of Congress no. 58-60781, Dunfey City Line Hotel, Philadel-phia,Pensylvania, US, pages 507-511;Phi-lips:"Random noise in digital gates and dividers"*Figure 5**

(56) Documents cités :
**ISA TRANSACTIONS. vol. 21, no. 4, 1982, PIT-TSBURGH US pages 37 - 44; A.L. LANCE ET AL.: "PHASE NOISE MEASUREMENT SYS-TEMS"**
**IEEE TRANSACTIONS ON MICROWAVE THEORY AND TECHNIQUES. vol. MTT16, no. 9, septembre 1968, NEW YORK US pages 761 - 766; K.H.SANN: "THE MEASUREMENT OF NEAR-CARRIER NOISE IN MICROWAVE AMPLIFIERS"**

(73) Titulaire : **THOMSON-CSF**
**51, Esplanade du Général de Gaulle**
**F-92800 Puteaux (FR)**

(72) Inventeur : **Durand, Jacques**
**Thomson-CSF, SCPI-Cédex 67**
**F-92045 Paris La Défense (FR)**

(74) Mandataire : **Guérin, Michel et al**
**THOMSON-CSF SCPI B.P. 329 50, rue Jean-Pierre Timbaud**
**F-92402 Courbevoie Cédex (FR)**

## Description

La présente invention concerne une chaîne de mesure de la caractéristique de bruit de phase additif d'un composant au voisinage d'une fréquence porteuse.

Le bruit de phase additif (par opposition au bruit de phase de source, que ne concerne pas l'invention) est le bruit de phase ou *jitter* ajouté par un composant donné d'un circuit.

L'invention permet avantageusement la mesure du bruit de phase produit par un diviseur de fréquence, qui est typiquement un composant pour lequel le bruit de phase est une caractéristique critique. Cette application n'a cependant aucun caractère limitatif, et l'invention peut aussi bien permettre la mesure des performances de tout composant générant un bruit de phase de nature additive (multiplicateur de fréquence, amplificateur, filtre actif, etc.).

La technique métrologique utilisée jusqu'à présent à cet effet consiste à produire, au moyen d'un générateur unique, une fréquence prédéterminée qui alimente conjointement et en quadrature deux voies identiques comprenant chacune un exemplaire du composant à caractériser. Les signaux obtenus en aval de ces composants dans chacune des voies sont appliqués aux entrées respectives d'un mélangeur combinant ces deux signaux et délivrant en sortie un signal fonction des écarts de phase instantanés entre les deux voies ; le signal en sortie du mélangeur, qui est ensuite détecté et amplifié, donne ainsi une indication du bruit de phase additif du composant à caractériser, le bruit de phase de source du générateur, qui se retrouve identiquement sur les deux voies, étant éliminé par le mélange.

Les limites de cette méthode, qui est basée sur le principe de la détection de phase simple, tiennent au fait que l'on recueille en sortie du mélangeur non seulement un signal représentatif du bruit de phase additif introduit par le composant à caractériser, mais également d'un bruit additif surajouté par le mélangeur (et ses circuits associés de détection et d'amplification) et par celui des des perturbations extérieures.

Or, en ce qui concerne le mélangeur, il est très difficile de quantifier son bruit de phase additif propre, qui n'est pas constant et varie notamment en fonction des niveaux de signal appliqués sur ses entrées.

Par ailleurs, en ce qui concerne les perturbations extérieures, les chaînes de mesure réalisées sur le principe précité sont extrêmement sensibles aux rayonnements et vibrations, du fait que le domaine dans lequel on cherche à caractériser le bruit de phase se situe dans une bande de fréquences étroite autour d'une fréquence centrale donnée (désignée ici fréquence porteuse"), typiquement dans une plage de 5 à 10 kHz autour de cette fréquence porteuse.

Ces fréquences basses correspondant à une amplitude élevée de parasites industriels induits par l'environnement, notamment les rayonnements et les vibrations (qui induisent des parasites dans le circuit par effet microphonique), il est nécessaire de prévoir des blindages et des montages antivibratoires extrêmement soignés et d'effectuer la caractérisation du composant dans un environnement métrologique à faible niveau de perturbations extérieures. Ceci augmente considérablement le coût de l'appareil et en limite les possibilités d'emploi.

Ainsi, en pratique, pour des composants à caractériser très performants en termes de bruit de phase, le bruit de phase propre du composant est couvert par le bruit de phase surajouté du mélangeur et des perturbations extérieures. Il est alors très difficile d'extraire le signal que l'on souhaite mesurer de ces interférences mêlées.

L'invention se propose de remédier à l'ensemble des inconvénients précités, en proposant une chaîne de mesure du bruit de phase additif d'un composant qui présente un très faible plancher de bruit. Par son architecture, la chaîne de mesure permettra d'éliminer l'influence à la fois des perturbations extérieures et des bruits de phase additifs inhérents aux autres composants de la chaîne et procurera ainsi une dynamique de mesure notablement supérieure à celle des chaînes de mesure connues.

Le document IEEE Transactions ou Microwave Theory and Techniques, Vol. MTT-16, n°9, Sept. 1968, pp 761-766 décrit un système de mesure tel que cela est prévu dans le préambule de la revendication 1.

La chaîne de mesure de la caractéristique de bruit de phase additif d'un composant au voisinage d'une fréquence porteuse selon l'invention comprend :

- une voie centrale et deux voies latérales, la voie centrale comportant un exemplaire dudit composant à caractériser,
- une source de signal à ladite fréquence porteuse, cette source étant une source commune alimentant identiquement la voie centrale et les voies latérales,
- des moyens pour déphaser le signal des voies latérales par rapport à celui de la voie centrale.

Cette chaîne de mesure est caractérisée par le fait que les moyens pour déphaser déphasent en quadrature le signal des voies latérales par rapport à celui de la voie centrale et qu'elle comprend également :

- dans chacune des deux voies latérales un exemplaire dudit composant à caractériser,
- deux circuits détecteurs de phase, combinant chacun le signal de la voie centrale au signal de l'une des voies latérales respective de manière à délivrer en sortie un signal fonction des écarts instantanés de phase entre les signaux appliqués en entrée, et

- des moyens pour intercorréler les signaux de sortie respectifs de ces deux circuits détecteurs, le résultat de cette intercorrélation permettant de déterminer la caractéristique de bruit de phase additif propre du composant à caractériser, extraite des bruits de phase additifs surajoutés par les autres éléments de la chaîne et par les perturbations extérieures induites.

Selon un certain nombre de caractéristiques avantageuses :

- les moyens pour déphaser en quadrature le signal des voies latérales par rapport à celui de la voie centrale comprennent deux déphaseurs en quadrature ajustables placés chacun dans l'une des voies latérales en série avec le composant ; dans ce cas, si le composant à caractériser est un composant à changement de fréquence, le déphaseur en quadrature ajustable placé en série avec celui-ci l'est de préférence du côté des fréquences les plus élevées ;
- il est prévu en outre dans chacune des voies latérales ou dans la voie centrale un filtre réjecteur, centré sur la fréquence porteuse et dont la largeur de bande est ajustée de manière à assurer, en sortie des circuits détecteurs de phase, la réjection des produits d'interspectres de bruits attachés aux raies composites engendrées par le composant ;
- chacune des voies latérales et/ou la voie centrale comprennent un atténuateur variable permettant d'ajuster les niveaux relatifs des signaux appliqués en entrée des circuits détecteurs de phase ;
- les circuits détecteurs de phase comprennent chacun un mélangeur et un circuit amplificateur et intégrateur en sortie de ce mélangeur ; et
- il est prévu en outre des moyens pour établir la transformée de Fourier du résultat de l'intercorrélation, de manière à déterminer la densité spectrale de puissance de bruit de phase du composant à caractériser.

On va maintenant décrire, en référence aux figures annexées, un exemple de mise en oeuvre de l'invention.

La figure 1 est une représentation schématique par blocs de la chaîne de mesure de l'invention.

La figure 2 illustre une caractéristique, relevé sur le circuit de la figure 1, donnant la densité spectrale de bruit plancher en fonction de l'écart par rapport à la fréquence porteuse.

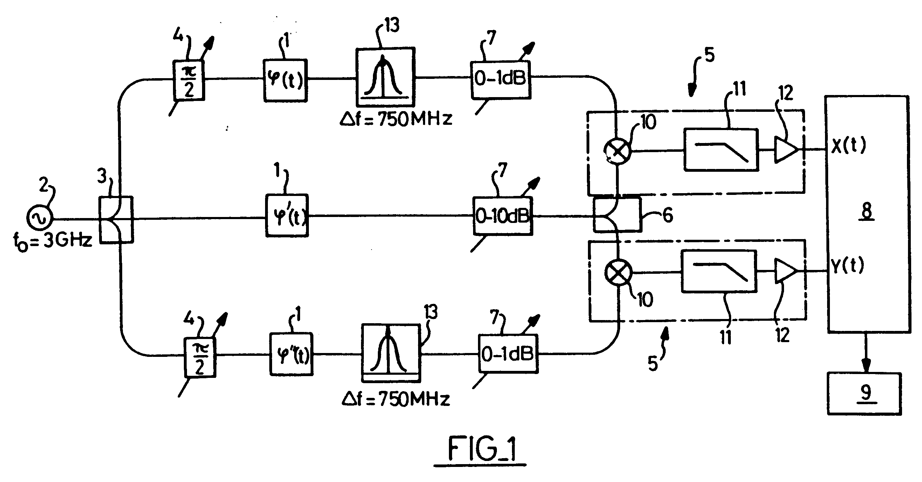

Sur la figure 1, la référence 1 désigne le composant à caractériser, dont trois exemplaires (supposés identiques) sont placés dans trois voies alimentées en commun par une source 2 de signal à la fréquence porteuse (par exemple, une source à la fréquence $f_o$

= 3 GHz, autour de laquelle on souhaite caractériser le composant) par l'intermédiaire d'un diviseur de puissance ou power splitter à trois voies, de manière à permettre un fonctionnement dynamique synchronisé des trois voies à la fréquence porteuse voulue. Les voies latérales comportent chacune un déphaseur $\pi/2$, ajustable, permettant de déphaser d'un quart de période le signal de chacune des voies latérales par rapport à celui de la voie centrale (en variante, on pourrait également utiliser un déphaseur unique placé sur la voie centrale, mais dans ce cas, il ne serait pas possible d'ajuster séparément la quadrature exacte de chacune des voies latérales).

On notera incidemment que, lorsque le composant à caractériser 1 est un composant à changement de fréquence, on place de préférence le déphaseur 4 du côté des fréquences les plus élevées, ce qui permet d'utiliser une ligne de plus faible dimension ; ainsi, si le composant 1 est un diviseur de fréquence, on placera le déphaseur 4 en amont de celui-ci et, inversement, s'il s'agit d'un multiplicateur de fréquence, on le placera en aval de ce multiplicateur.

Le signal en sortie de la voie centrale est combiné au signal en sortie de chacune des voies latérales dans un circuit détecteur de phase 5 recevant sur ses entrées les signaux correspondants, le signal de la voie centrale étant réparti identiquement sur les deux détecteurs de phase 5 au moyen d'un diviseur de puissance à deux voies 6. Des atténuateurs 7, placés en sortie des différentes voies, permettent d'ajuster les niveaux d'entrée des détecteurs de phase 5 de manière à avoir rigoureusement les mêmes niveaux sur les deux entrées de chacun des mélangeurs ; ceci permet d'assurer l'ajustement précis de la quadrature par détection de zéro en sortie du circuit 5.

Les sorties X(t) et Y(t) respectives des détecteurs de phase 5 sont appliquées à une unité d'acquisition et de traitement 8 (par exemple un micro-ordinateur attaqué en entrée par un convertisseur analogique/numérique) qui numérise (par exemple sur 12 bits), échantillonne et enregistre les données pendant un temps d'observation suffisant pour que les opérations effectuées sur ces différents échantillons fournissent un résultat significatif (au sens des règles du traitement numérique du signal) ; les résultats obtenus seront visualisés en 9.

En ce qui concerne les circuits détecteurs de phase 5, chacun d'entre eux comporte un mélangeur 10, qui est un mélangeur double équilibré à diodes de type classique, compatible en puissance avec les signaux utilisés (le bruit propre de ce mélangeur, contrairement aux techniques de l'art antérieur, est sans importance dans le choix du mélangeur car, comme on l'expliquera plus loin, ce bruit propre sera éliminé par le traitement exécuté dans l'unité 8).

On obtient en sortie du mélangeur 10 un signal représentatif des écarts de phase entre le signal de la voie centrale et celui de la voie latérale correspondante, sous la forme d'une tension continue proportionnelle à cet écart de phase, à laquelle se surajoute le bruit additif des éléments de la chaîne (essentiellement celui du composant à caractériser 1 et celui du mélangeur 10). Si l'on ajuste convenablement les niveaux au moyen des atténuateurs 7, la tension continue en sortie du mélangeur sera nulle (quadrature rigoureuse) et le seul signal délivré sera donc le signal de bruit de phase.

Ce signal de bruit de phase, qui est de très faible niveau (typiquement, de l'ordre de quelques microvolts sur une impédance de 50 $\Omega$) est amplifié et intégré par un ensemble comprenant un filtre passe-bas 11 et un amplificateur 12, donnant ainsi en sortie un signal X(t) ou Y(t) compatible en niveau (quelques volts) et en impédance (haute impédance) avec le convertisseur analogique/numérique de l'unité d'acquisition 8 ; le filtre passe-bas 11 assure la réjection des composantes de mélange d'ordre supérieur à celui de la fréquence porteuse $f_o$.

Avantageusement, il est prévu en outre, dans chacune des voies latérales, un filtre 13 centré sur la fréquence porteuse et dont la sélectivité est choisie de manière à réduire les effets de non-linéarité dûs aux produits d'interspectres après mélange : en effet, certains composants à caractériser 1 (tels que les diviseurs de fréquence tout particulièrement) génèrent en sortie des harmoniques, de niveau relativement important, du signal à la fréquence porteuse qui leur est appliqué en entrée ; les raies harmoniques ainsi produites sont bien entendu affectées du même bruit de phase que la raie principale, à laquelle on s'intéresse.

Or, comme les mélangeurs 10 agissent en multiplicateurs de fréquence, ils vont donner des produits à partir de toutes les raies parasites et donc sur tous les interspectres liés à ces raies parasites et, en l'absence de précautions particulières, la caractéristique de bruit donnée par la chaîne de mesure prendrait en compte cette anomalie, ce qui dégraderait d'autant le plancher de bruit global de la chaîne de mesure.

C'est pour cette raison que l'on prévoit le filtre 13 qui permet, en sortie du composant, d'éliminer la totalité des raies parasites générées par le composant 1, en ne conservant que la raie principale correspondant à la fréquence porteuse fondamentale $f_o$. Dans le cas particulier d'un diviseur de fréquence par 4 et d'une fréquence porteuse de 3 GHz, on peut ainsi utiliser un filtre ne laissant passer qu'une largeur de bande de 750 MHz autour de la fréquence porteuse.

On notera qu'il n'est pas nécessaire de prévoir un tel filtre dans la voie centrale : en effet, le rôle de ce filtre est d'éliminer les produits d'interspectres et il suffit d'éliminer les raies parasites de l'un des deux facteurs de ce produit pour atteindre le résultat voulu.

Il est préférable que le filtre 13 soit un filtre passif, pour ne pas introduire de bruit de phase additif propre qui viendrait créer une perturbation supplémentaire.

On va maintenant décrire le traitement du signal opéré par l'unité d'acquisition et de traitement 8.

On supposera que le bruit de phase additif introduit par le composant à caractériser est un bruit sans particularité fondamentale, c'est-à-dire que, en ce qui concerne la nature des sources de bruit, il vérifie les hypothèses classiques de stationnarité, indépendance et distribution spectrale gaussienne.

Si l'on suppose que l'on a réalisé une quadrature exacte, on obtient des signaux X(t) et Y(t) de la forme suivante (les fluctuations de phase étant très faibles, on assimile $\varphi$ à sin $\varphi$):

$$X(t) = K_x [\varphi'(t) - \varphi(t)] + b_x(t),$$

et

$$Y(t) = K_y [\varphi'(t) - \varphi''(t)] + b_y(t),$$

$\varphi(t)$, $\varphi'(t)$ et $\varphi''(t)$ étant les bruits de phase additifs (variables aléatoires) respectivement introduits par les composants 1 de la première voie latérale, de la voie centrale et de la seconde voie latérale,

$K_x$ et $K_y$ étant des constantes liées au gain du mélangeur et du circuit amplificateur/intégrateur 11,12, et

$b_x(t)$ et $b_y(t)$ étant les bruits de phase additifs (variables aléatoires également) des organes de détection (mélangeur et amplificateur) de chaque voie.

Les bruits de phase propres $b_x(t)$ et $b_y(t)$ constituaient dans la technique antérieure une nuisance que, grâce à la présente invention, on va pouvoir éliminer, ce qui procurera ainsi un accroissement de la dynamique de mesure du système.

On va montrer la manière dont, dans l'unité d'acquisition et de traitement 8, on peut extraire par intercorrélation de ces deux signaux K(t) et Y(t) la densité spectrale de puissance de bruit de phase attachée au composant 1 inséré dans la voie centrale.

En effet, si l'on exprime selon l'algèbre des espérances mathématiques la fonction intercorrélation $R_{xy}$ des deux signaux X(t) et Y(t), on obtient:

$$R_{xy}(\tau) = E\{X(t) Y(t - \tau)\},$$

soit:

$$R_{xy}(\tau) = K_x K_y E\{\varphi'(t) - \varphi'(t - \tau)\}.$$

Compte tenu de l'hypothèse faite plus haut d'indépendance des événements associés dans les autres termes de l'opération, et si l'on a $K_x = K_y = K$, K étant une valeur connue (les mélangeurs et leurs circuits associés étant étalonnés), on obtient:

$$R_{xy}(\tau) = K^2 C[\varphi'(t)],$$

c'est-à-dire, à un facteur près, la fonction d'autocorrélation de la variable aléatoire $\varphi'(t)$. La transformée de Fourier de cette fonction d'autocorrélation (domaine temporel) donne la densité spectrale (domaine fréquentiel) de puissance de bruit de phase, qui est la caractéristique généralement recherchée.

En d'autres termes, tout ce qui, sur les voies extérieures, est corrélé (tout particulièrement, le bruit de phase additif surajouté par le mélangeur 10) disparaît, et l'on obtient comme résultat du traitement l'autocorrélation du bruit de phase additif introduit dans la voie du milieu, c'est-à-dire le bruit de phase additif du seul composant 1.

On obtient ainsi une augmentation importante de la dynamique par rapport aux systèmes de l'art antérieur : le gain théorique que l'on peut ainsi obtenir est de l'ordre de 20 dB, et l'on constate qu'une chaîne de mesure simple, réalisée sans précaution particulière en ce qui concerne la protection contre les rayonnements et les vibrations, procure déjà un gain supérieur à 6 dB par rapport à une chaîne de mesure de l'art antérieur très protégée contre les rayonnements et les vibrations, donc de coût notablement supérieur.

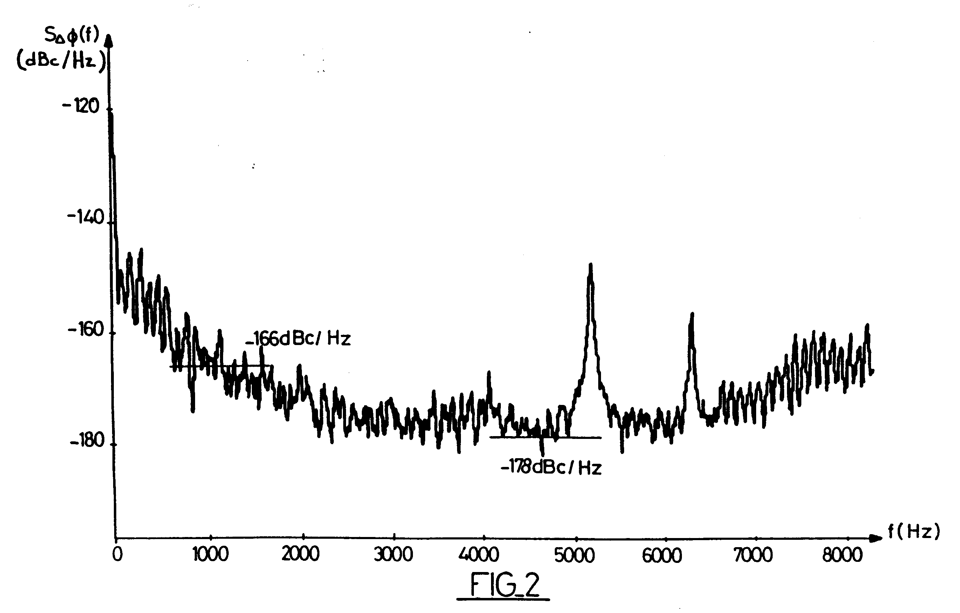

La figure 2 illustre le plancher de bruit du système (c'est-à-dire le bruit obtenu en court-circuitant les composants à caractériser), donné par la densité spectrale $S_{\Delta\varphi}(f)$ en fonction de l'écart f de fréquence par rapport à la fréquence porteuse (ici, une fréquence de 3 GHz). On voit que l'on obtient un bruit plancher minimal de l'ordre de - 178 dBc/Hz - valeur inférieure au bruit thermique - et un plancher de bruit nominal à 1000 Hz de - 166 dBc/Hz.

## Revendications

1. Chaîne de mesure de la caractéristique de bruit de phase additif d'un composant (1) au voisinage d'une fréquence porteuse (fo), comprenant :
   - une voie centrale et deux voies latérales, la voie centrale comportant un exemplaire dudit composant (1) à caractériser,
   - une source (2) de signal à ladite fréquence porteuse (fo), cette source étant une source commune alimentant identiquement la voie centrale et les voies latérales,
   - des moyens (4) pour déphaser le signal des voies latérales par rapport à celui de la voie centrale, caractérisée en ce que les moyens (4) pour déphaser déphasent en quadrature le signal des voies latérales par rapport à celui de la voie centrale, et en ce que la chaine de mesure comprend également :
   - dans chacune des deux voies latérales un exemplaire dudit composant (1) à caractériser,
   - deux circuits détecteurs de phase (5), combinant chacun le signal de la voie centrale au signal de l'une des voies latérales respective de manière à délivrer en sortie un signal (X(t) ; Y(t)) fonction des écarts instantanés de phase ($\varphi'(t)-\varphi(t)$ ; $\varphi'(t)-\varphi''(t)$) entre les signaux appliqués en entrée, et
   - des moyens (8) pour intercorréler les signaux de sortie respectifs de ces deux circuits détecteurs (5), le résultat de cette intercorrélation permettant de déterminer la caractéristique de bruit de phase additif propre du composant (1) à caractériser, extraite des bruits de phase additifs surajoutés par les autres éléments de la chaîne et par les perturbations extérieures induites.

2. Chaîne de mesure selon la revendication 1, dans laquelle les moyens pour déphaser en quadrature le signal des voies latérales par rapport à celui de la voie centrale comprennent deux déphaseurs en quadrature ajustables (4) placés chacun dans l'une des voies latérales en série avec le composant.

3. Chaîne de mesure selon la revendication 2, dans laquelle, lorsque le composant (1) à caractériser est un composant à changement de fréquence, le déphaseur en quadrature ajustable (4) placé en série avec celui-ci l'est du côté des fréquences les plus élevées.

4. Chaîne de mesure selon la revendication 1, comprenant en outre dans chacune des voies latérales ou dans la voie centrale un filtre réjecteur (13), centré sur la fréquence porteuse (fo) et dont la largeur de bande est ajustée de manière à assurer, en sortie des circuits détecteurs de phase (5), la réjection des produits d'interspectres de bruits attachés aux raies composites engendrées par le composant.

5. Chaîne de mesure selon la revendication 1, dans laquelle chacune des voies latérales et/ou la voie centrale comprennent un atténuateur variable (7) permettant d'ajuster les niveaux relatifs des signaux appliqués en entrée des circuits détecteurs de phase.

6. Chaîne de mesure selon la revendication 1, dans laquelle les circuits détecteurs de phase (5) comprennent chacun un mélangeur (10) et un circuit amplificateur (12) et intégrateur (11) en sortie de ce mélangeur.

7. Chaîne de mesure selon la revendication 1, comprenant en outre des moyens (8) pour établir la transformée de Fourier du résultat de l'intercorrélation, de manière à déterminer la densité spectrale de puissance de bruit de phase du composant (1) à caractériser.

## Patentansprüche

1. Meßkette zur Messung der Charakteristik des additiven Phasenrauschens eines Bauelements (1) in der Nähe einer Trägerfrequenz ($f_o$),
   - mit einem mittleren Kanal und zwei Seitenkanälen, wobei der mittlere Kanal ein Exemplar des zu charakterisierenden Bauelements (1) enthält,
- mit einer Quelle (2) eines Signals mit der Trägerfrequenz ($f_o$), wobei diese Quelle eine gemeinsame Quelle ist, die in gleicher Weise den mittleren und die Seitenkanäle speist,
- mit Mitteln (4), um die Phase des Signals der Seitenkanäle bezüglich der des mittleren Kanals zu verschieben,
dadurch gekennzeichnet, daß die Phasenschiebermittel (4) das Signal der Seitenkanäle bezüglich des Signals des mittleren Kanals in Quadratur setzen und daß die Meßkette weiter aufweist:
- in jedem der beiden Seitenkanäle ein Exemplar des zu charakterisierenden Bauelements (1),
- zwei Phasendetektorkreise (5), die je das Signal des mittleren Kanals mit dem Signal eines der Seitenkanäle kombinieren und am Ausgang ein Signal (X(t); Y(t)) liefern, das von den Augenblickswerten des Phasenabstands ($\varphi$'(t)-$\varphi$(t); $\varphi$'(t)-$\varphi$"(t)) zwischen den an die Eingänge angelegten Signalen abhängt,
- und Mittel (8), um die Ausgangssignale der beiden Detektorkreise (5) miteinander zu korrelieren, wobei das Ergebnis dieser Interkorrelation die Charakteristik des für das zu charakterisierende Bauelement (1) typischen additiven Phasenrauschens zu bestimmen vermag, die aus dem additiven Phasenrauschen extrahiert wird, das von den anderen Bauelementen der Kette und von den von außen induzierten Störungen hinzugefügt wird.

2. Meßkette nach Anspruch 1, in der die Mittel, die das Signal der Seitenkanäle bezüglich des Signals des mittleren Kanals in Quadratur setzen, zwei justierbare Quadraturphasenschieber (4) enthalten, die je in einem der Seitenkanäle in Reihe mit dem Bauelement liegen.

3. Meßkette nach Anspruch 2, in der der in Reihe mit dem zu charakterisierenden Bauelement (1) liegende justierbare Quadraturphasenschieber (4) auf der Seite der höheren Frequenzen liegt, falls das Bauelement die Frequenz verändert.

4. Meßkette nach Anspruch 1, bei der außerdem in jedem der Seitenkanäle oder im mittleren Kanal ein Sperrfilter (13) liegt, das auf die Trägerfrequenz ($f_o$) zentriert ist und dessen Bandbreite so festgelegt ist, daß am Ausgang der Phasendetektorkreise (5) die Interspektralprodukte des Rauschens aufgrund der von dem Bauelement erzeugten kombinierten Spektrallinien ausgesperrt werden.

5. Meßkette nach Anspruch 1, in der jeder Seitenkanal und/oder der mittlere Kanal ein variables Dämpfungsglied (7) enthält, mit dem die Pegel der an die Eingänge der Phasendetektorkreise angelegten Signale relativ aneinander angepaßt werden können.

6. Meßkette nach Anspruch 1, in der die Phasendetektorkreise (5) je eine Mischstufe (10) und einen Verstärkerkreis (12) sowie einen Integrator (11) am Ausgang dieser Mischstufe enthalten.

7. Meßkette nach Anspruch 1, in der weiter Mittel (8) vorgesehen sind, um die Fouriertransformierte des Interkorrelationsergebnisses zu erstellen, so daß die spektrale Leistungsdichte des Phasenrauschens des zu charakterisierenden Bauelements (1) bestimmt werden kann.

## Claims

1. Chain for measuring the additive phase noise characteristic of a component (1) near a carrier frequency (fo), comprising:
- a central path and two side paths, the central path including a specimen of the said component (1) to be characterized,
- a signal source (2) at the said carrier frequency (fo), this source being a common source feeding the central path and the side paths identically,
- means (4) for phase-shifting the signal of the side paths with respect to that of the central path, characterized in that the phase-shifting means (4) quadrature phase shift the signal of the side paths with respect to that of the central path, and in that the measurement chain also comprises:
- in each of the two side paths a specimen of the said component (1) to be characterized,
- two phase detector circuits (5) each combining the signal from the central path with the signal from one of the respective side paths so as to output a signal (X(t); Y(t)) dependent on the instantaneous phase deviations ($\phi$'(t)-$\phi$(t); $\phi$'(t)-$\phi$"(t)) between the signals applied at input, and
- means (8) for cross-correlating the respective output signals from these two detector circuits (5), the result of this cross-correlation making it possible to determine the additive phase noise characteristic which is specific to the component (1) to be characterized and is extracted from the additive phase noises contributed by the other elements of the chain and by the induced outside disturbances.

2. Measurement chain according to Claim 1, in which the means for quadrature phase shifting the signal of the side paths with respect to that of the central path comprise two adjustable quadrature phase shifters (4) each placed in one of the side paths in series with the component.

3. Measurement chain according to Claim 2, in which, when the component (1) to be characterized is a change of frequency component, the adjustable quadrature phase shifter (4) placed in series with it is so on the highest frequency side.

4. Measurement chain according to Claim 1, furthermore comprising in each of the side paths or in the central path a rejection filter (13) centred on the carrier frequency (fo) and whose bandwidth is adjusted so as to ensure, at the output of the phase detector circuits (5), rejection of the cross-spectral products of noises linked with the composite spectral lines generated by the component.

5. Measurement chain according to Claim 1, in which each of the side paths and/or the central path comprise a variable attenuator (7) making it possible to adjust the relative levels of the signals input to the phase detector circuits.

6. Measurement chain according to Claim 1, in which the phase detector circuits (5) each comprise a mixer (10) and an amplifier (12) and integrator (11) circuit at the output of this mixer.

7. Measurement chain according to Claim 1, furthermore comprising means (8) for producing the Fourier transform of the result of the cross-correlation, in such a way as to determine the phase noise spectral power density of the component (1) to be characterized.

FIG_1

FIG_2